# EUROPEAN PATENT APPLICATION

(11) **EP 2 559 938 A2**
(43) Date of publication of application: **20.02.2013**
(21) Application number: 12180183.1
(22) Date of filing: 10.08.2012
(51) Int. Cl.: F21V 29/00, F21K 99/00

(54) **Heat sink for LED lamp**

(30) Priority: 16.08.2011 TW 100215239
(71) Applicant: Chen, Shyh-Ming, New Taipei City (TW)
(72) Inventor: Chen, Shyh-Ming, New Taipei City (TW)
(74) Representative: Lang, Christian

(57) **Abstract**

The heat sink includes a tube and a plurality of fins. The tube has slots and grooves. Each the groove is located between two adjacent ones of the grooves. The fins are separately fastened to the slots. Each the fin has two walls separately fastened to two of the grooves and a bridge connected between the two walls. An airflow passage is formed among the bridge and the walls.

## Description

### Background of the Invention

### 1. Technical Field

The invention relates to heat sinks, particularly to radial heat sinks.

### 2. Related Art

Heat sinks are an essential element for many kinds of electric devices, particularly for LED lamps which are progressively popular around the world. High temperature of heat sinks easily cause scalds to users, especially to children.

Korean patent No. 10-0994603 (hereinafter "KR '603") discloses a radial heat sink. As shown in FIG. 7 of KR '603, all fins are formed by folding a single sheet of metal. In other words, all fins are continuous. Such a structure requires a forming process and a folding process with very high accuracy. An allowable error is very narrow. This will increase manufacturing costs.

### Summary of the Invention

An object of the invention is to provide a heat sink which uses separate fins and a tube to combine together so as to reduce manufacturing accuracy and costs.

To achieve the above object, the heat sink of the invention includes a tube and a plurality of fins. The tube has slots and grooves. Each the groove is located between two adjacent ones of the grooves. The fins are separately fastened to the slots. Each the fin has two walls separately fastened to two of the grooves and a bridge connected between the two walls. An airflow passage is formed among the bridge and the walls.

### Brief Description of the Drawings

FIG. 1 is a perspective view of the fin of the invention;
FIG. 2 is an exploded view of the invention;
FIG. 3 is a top plan view of the invention;
FIG. 4 shows the invention is combined with a heat source;

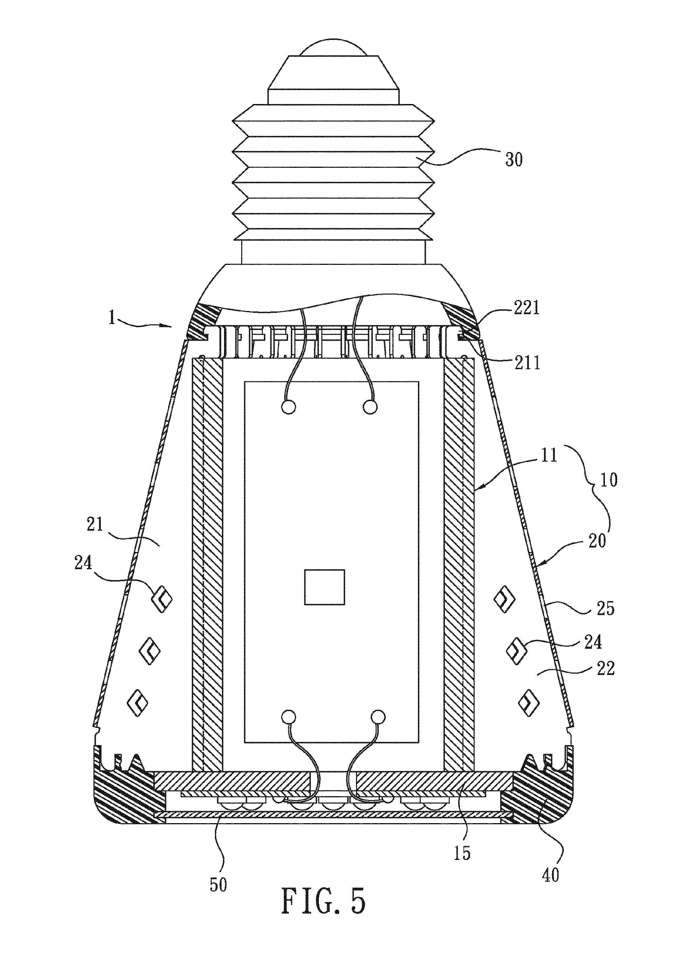

FIG. 5 is a cross-sectional view of FIG. 4;
FIG. 6 is a perspective view of the fin of another embodiment;
FIG. 7 is a perspective view of the fin of still another embodiment; and
FIG. 8 is a perspective view of the fin of yet another embodiment.

### Detailed Description of the Invention

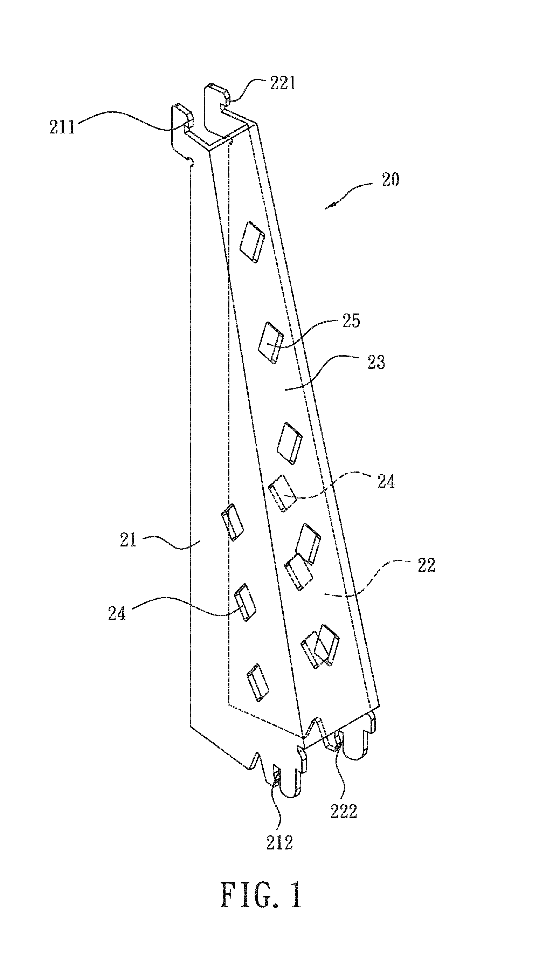

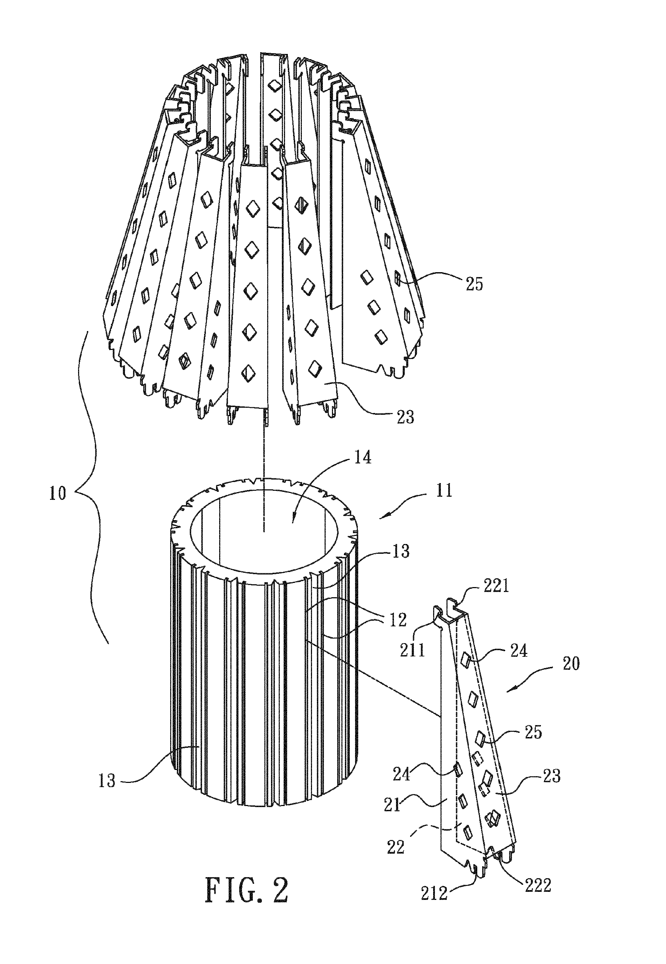

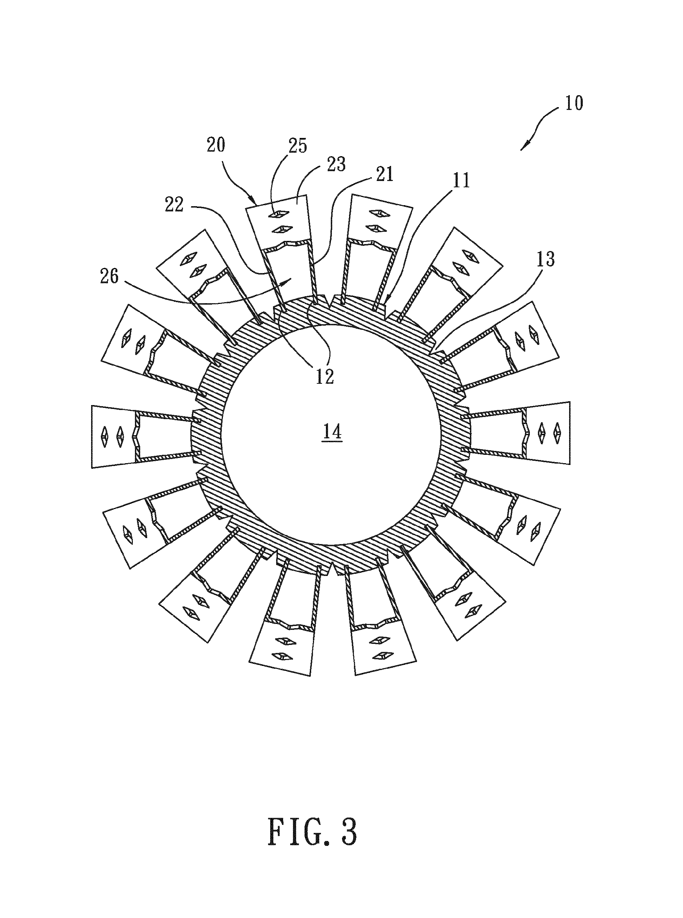

Please refer to FIGS. 1-3. The heat sink of the invention includes a tube 11 and a plurality of fins 20. The outside of the tube 11 is formed with slots 12 for being fastened by the fins 20 and grooves 13. Each of the grooves 13 is located between two adjacent ones of the slots 12 for being inserted by a mold (not shown). A hollow 14 of the tube 11 is used for receiving a heat source. Each of the fins 20 has two walls 21, 22 and a bridge 23 therebetween. The bridge can be planar or non-planar such as an arcked surface or a bent surface. Internal sides of the walls 21, 22 are separately inserted into the slots 12 so that the fins 20 are radially arranged around the tube 11. When the grooves 13 are pressed by the mold, the grooves 13 will be deformed to make the slots 12 tightly nip the fins 20.

Each of the walls 21, 22 of the fins 20 is disposed with three through holes 24 and the bridge 23 is disposed with five through holes 25. An airflow passage 26 is formed by the walls 21, 22 and the bridge 23. This can improve efficiency of convection.

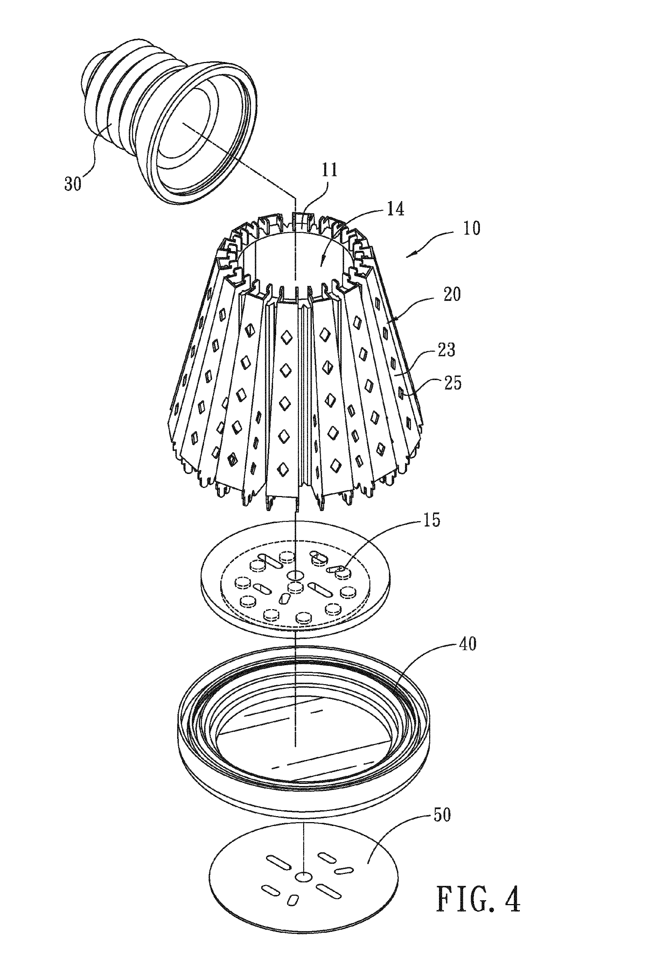

Please refer to FIGS. 1 and 4. The tops of the walls 21, 22 are separately formed with two engagement portions 211, 221 for connecting a base 30 and the bottoms of the walls 21, 22 are separately formed with two recesses 212, 222 for connecting a frame 40 to form an LED lamp 1. Further, the heat source 15 may be cloaked by a cover 50. The cover 50 is made of metal or plastic and fastened in the frame 40.

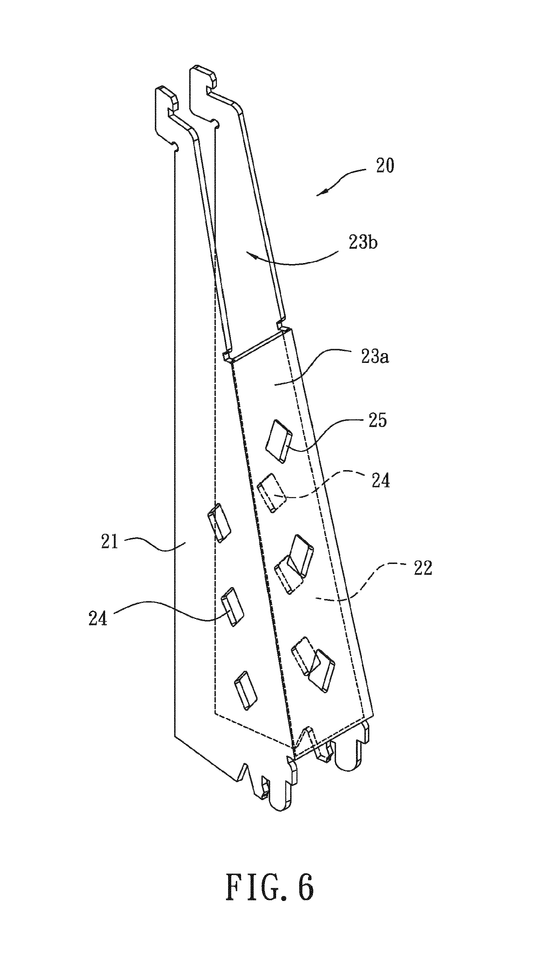

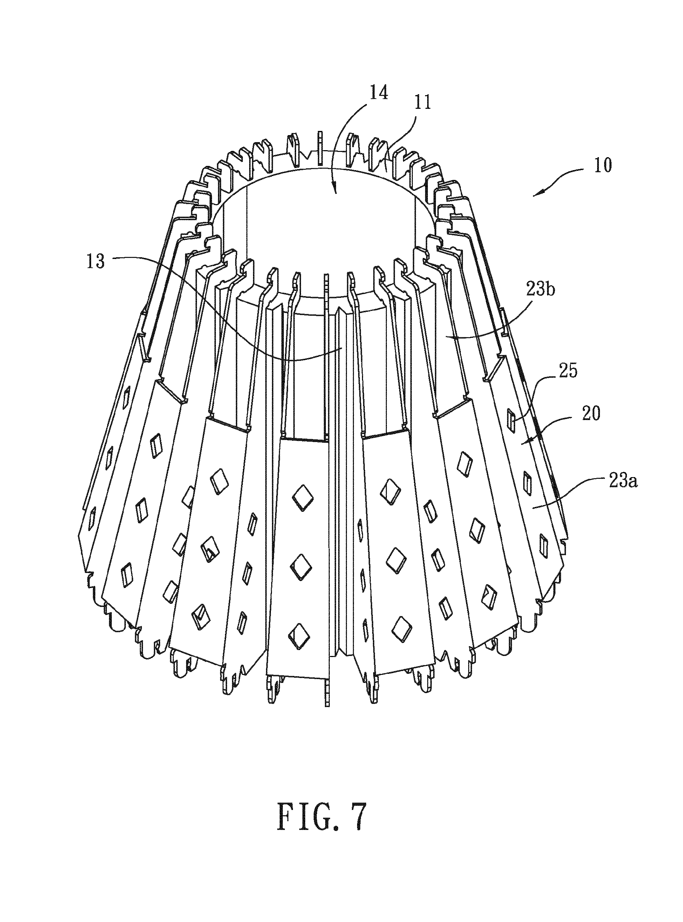

Please refer to FIGS. 6 and 7, which show another embodiment of the invention. In this embodiment, the bridge 23a is provided with an open area 23b to improve effect of convection.

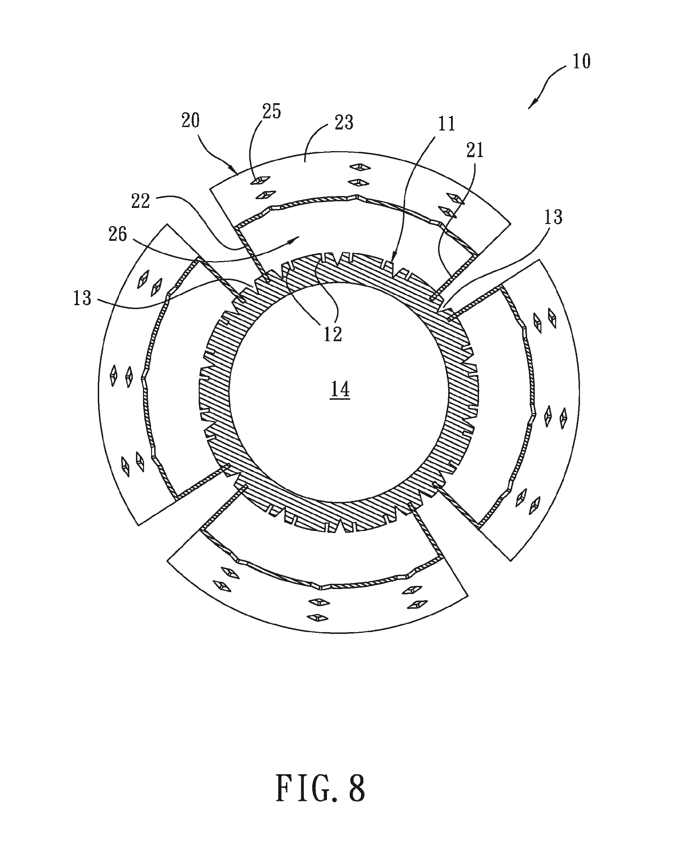

FIG. 8 shows still another embodiment of the invention. In this embodiment, the fins 20 are four in number.

It will be appreciated by persons skilled in the art that the above embodiments have been described by way of example only and not in any limitative sense, and that various alterations and modifications are possible without departure from the scope of the invention as defined by the appended claims.

## Claims

1. A heat sink comprising:
a tube, having slots and grooves, wherein each the groove is located between two adjacent ones of the grooves; and
a plurality of fins, separately fastened to the slots, wherein each the fin has two walls separately fastened to two of the grooves and a bridge connected between the two walls, and an airflow passage is formed among the bridge and the walls.

2. The heat sink of claim 1, further comprising a bridge disposed between the two walls.

3. The heat sink of claim 2, wherein the bridge has at least one through hole.

4. The heat sink of claim 1, wherein each of the walls is provided with at least one through hole.

5. The heat sink of claim 1, wherein a top of each the fin has an engagement portion.

6. The heat sink of claim 1, wherein a bottom of each the fin has a recess.

7. The heat sink of claim 1, wherein the bridge has an open area.

8. The heat sink of claim 1, wherein the bridge is planar.
